# EUROPEAN PATENT SPECIFICATION

(11) **EP 0 675 131 B1**
(45) Date of publication and mention of the grant of the patent: **01.12.1999**
(21) Application number: 95200730.0
(22) Date of filing: 23.03.1995
(51) Int. Cl.: C07F 9/655, C08K 5/5397

(54) **Fire retardant epoxy resin composition**
Flammhemmende Epoxyharzzusammensetzung
Composition de résine époxy ignifugeante

(30) Priority: 24.03.1994 EP 94200777
(43) Date of publication of application: 04.10.1995
(73) Proprietor: SHELL INTERNATIONALE RESEARCH MAATSCHAPPIJ B.V., 2596 HR Den Haag (NL)
(72) Inventor: Hitchings, Gregory John, NL-1031 CM Amsterdam (NL); Raudenbusch, Werner Theodor, NL-1031 CM Amsterdam (NL); Verburg, Antoon, NL-1544 XP Zaandijk (NL); Vrijenhoek, Jan Pieter, NL-1031 CM Amsterdam (NL)

(56) References cited:
- EP-A- 0 066 171
- EP-A- 0 095 453

## Description

The present invention relates to phosphorous containing polyglycidylether compounds, to a process for the preparation thereof, to curable fire retardant epoxy resin compositions comprising at least one of the said phosphorous containing polyglycidyl- ether compounds, to the use of the said compositions for the preparation of printed wiring boards, to articles, in particular printed wiring boards, comprising such curable compositions in the cured state and to a process for the preparation of such curable compositions.

Epoxy resin compositions are commonly used in the electronics and electrical industry. Some typical examples thereof are their use in printed wiring boards (previously called printed circuit boards), in electrical castings and pottings, and as encapsulating material of semiconductors.

These application areas not only require the epoxy resin composition to have excellent combinations of mechanical, electrical and physical properties but in addition to have a high degree of fire resistance or inflammability.

Up to date the most commonly used fire retardant epoxy resin compositions, particularly suitable for use in the preparation of laminates for printed wiring boards, have been based on conventional brominated epoxy resins such as the diglycidylether of tetrabromodiphenylolpropane, or on epoxy resins prepared by reacting a liquid epoxy resin with tetrabromodiphenylolpropane, and further a curing compound such as dicyandiamide and an accelerator such as an imidazole. In these compositions the desired level of fire retardancy, which is a rating of V=0 according to the fire retardancy test method UL 94V, can only be obtained when bromine is present in an amount of from approximately 10 percent to 25 percent by weight, based on the total weight of the composition. The negative environmental aspects associated with halogen containing compositions triggered the search for alternative fire retardant epoxy resin compositions which allow a significantly lower halogen content at the same level of fire retardancy whilst the other physical/electrical and mechanical properties of the epoxy resin composition remain at the required level for the applications referred to above.

Such alternative fire retardant epoxy resin compositions are disclosed in US patent No. 4,345,059, which relates to epoxy resin compositions comprising 3-hydroxyalkylphosphine oxides as fire retardant agents.

These compositions however have a number of disadvantages.

Firstly, since 3-hydroxyalkylphosphine oxides often are poorly soluble in the epoxy resin monomer, strong organic solvents such as dimethylsulfoxide, dimethylformamide or a halogenated solvent must often be used during the resin formulation or resin preparation to ensure that a homogeneous blend is obtained.

This involves an extra step in the preparation of the epoxy resin composition and, in addition, the use of organic solvents is becoming increasingly unacceptable from an environmental point of view.

Secondly, since the 3-hydroxyalkylphosphine oxides are not usually reactive under the conditions of normal epoxy resin cure regimes, for example those applied in printed wiring board manufacture, they will not be chemically bound to the resin matrix at the end of the cure cycle, but will be incorporated therein as non bonded inert additives.

This involves a risk of the leaching-out of the phosphine oxides from the cured resin composition which in time would lead to a reduction in fire retardancy. Furthermore the presence of inert additive species will deteriorate the overall properties of the cured resin.

In US patent No. 4,345,059 a possible solution for this problem is given by prereacting the 3-hydroxyalkylphosphine oxide with an anhydride compound at a temperature between 70 and 120 °C, prior to formulation with the epoxy resin. This is again an additional step in the preparation of the epoxy resin composition and introduces ester bonds in said composition, which may have a negative effect on the hydrolytic stability and on the water absorption of said composition in the cured state.

The problem underlying the present invention is to prepare a fire retardant epoxy resin composition that has a low halogen content or that is halogen free and that does not have the above mentioned disadvantages associated with the epoxy resin compositions comprising a 3-hydroxyalkylphosphine oxide as fire retardant agent.

The present invention therefore relates in particular to a curable fire retardant epoxy resin composition comprising
a) at least one phosphorous free epoxy resin compound,
b) at least one polyglycidylether of the general formula I as defined below 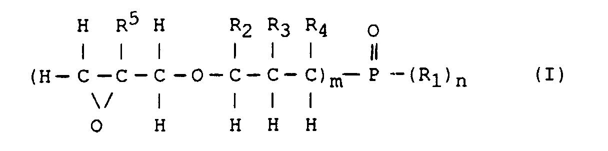
   - wherein m is 2 or 3, n is 0 or 1 and m+n is 3 and
   - wherein wherein R₁ is a radical of an optionally branched alkyl group having from 1 to 6 carbon atoms, of a cycloaliphatic group or of an aromatic group,
   - wherein each R₂ and R₃ may individually be a radical of hydrogen or of a linear alkyl group having from 1 to 4 carbon atoms,
   - wherein R₄ is a radical of hydrogen or of a linear alkyl group having from 1 to 4 carbon atoms, or of an aromatic group and
   - wherein R₅ is a radical of hydrogen or of a methyl group,
   and
c) a curing compound.

Compositions according to the present invention were found to show excellent fire retardancy at very low halogen content and even in the total absence of halogen. V=0 ratings according to the fire retardancy test UL 94 were obtained with compositions of the present invention containing zero percent of halogen and 5% phosphorous, both percentages based on the total weight of the composition.

Moreover, as compared to the above discussed prior art epoxy resin compositions comprising 3-hydroxyalkylphosphine oxides as fire retardant agents, the compositions of the present invention are easier to formulate since the compounds of the general formula I are more soluble in standard epoxy resins, and in addition have in the cured state a) a higher glass transition temperature and b) an expected better retention of fire retardancy in course of time.

The present invention also relates to the polyglycidylethers according to general formula I as defined above. Preferred groups R₁ are radicals of an optionally branched alkyl group having from 1 to 6 carbon atoms and preferred groups R₂, R₃ and R₄ are each individually radicals of hydrogen or of a methyl-, ethyl- or propyl group and group R₅ is preferably a radical of hydrogen. Particularly preferred polyglycidylethers according to the general formula I are those wherein R₁ is a radical of a methyl-, ethyl-, propyl-, isopropyl-, butyl- or sec-butyl group and wherein each R₂, R₃, R₄ and R₅ are a radical of hydrogen. Most preferred polyglycidylethers of the general formula I are the triglycidylether of tri(3-hydroxypropyl)phosphine oxide (TGE-FRT) and the diglycidylether of di(3-hydroxypropyl)2-methylpropylphosphine oxide (DGE-FRD).

The epoxy resin composition according to the present invention comprises at least one polyglycidylether compound according to the general formula I, and therefore may comprise a mixture of at least two thereof.

Polyglycidylethers according to the general formula I can be prepared by reacting the precursor 3-hydroxylalkylphosphine oxide compound with a suitable amount of epihalohydrin, preferably epichlorohydrin, in the presence of a suitable base or acid catalyst according to methods known in the art.

The amount of the polyglycidylether of the general formula I present in the composition of the present invention, is preferably such that the percentage of of phosphorous is of from 1 to 7 percent by weight, more preferably from 3 to 7 percent by weight, based on the total weight of the composition. Lower amounts of phosphorous will not give the desired level of fire retardancy whereas higher amounts thereof will be unfavourable from an economical point of view.

The choice of phosphorous free epoxy resin compound (hereafter referred to as "epoxy resin compound") used in the composition of the present invention is not critical and will depend on the area of application of the epoxy resin composition. For electrical and electronics end uses it is preferred to use one or more aromatic epoxy resin compounds optionally in admixture with one or more cycloaliphatic and/or aliphatic epoxy resin compound(s). Examples of suitable epoxy resin compounds are the diglycidylether of diphenylolpropane, the diglycidylether of diphenylolmethane or the advanced products thereof; the polyglycidylethers of diphenylolpropane/formaldehyde resins, of diphenylolmethane/formaldehyde resins, of phenol/formaldehyde resins and of cresol/formaldehyde resins; the diglycidylether of resorcinol; tetrakis(p-glycidylphenyl)ethane; the polyglycidylesters of phthalic- isophthalic- therephthalic- and trimellitic acid; N,N-diglycidylaniline, N,N,O-triglycidyl-p-aminophenol, triglycidylisocyanurate, N,N,N',N'-tetraglycidyl-bis-(p-aminophenyl)-methane; di- and polyglycidyl compounds of polyfunctional alcohols such as 1,4-butanediol, trimethylolpropane and polyalkyleneglycol and halogenated epoxy resin compounds such as the diglycidylether of tetrabromodiphenylolpropane and the reaction products of a liquid epoxy resin, such as the diglycidylether of diphenylolpropane, with tetrabromodiphenylolpropane. When the epoxy resin composition of the present invention comprises one or more halogenated epoxy resin compounds, the total halogen content of the composition may not exceed about 15%, preferably about 10% and more preferably about 5% by weight, based on the total weight of the composition. Preferred epoxy compounds are:
- the diglycidylether of diphenylolpropane, of diphenylolmethane and of tetrabromodiphenylolpropane and the advanced products of said diglycidylethers or
- the polyglycidylethers of diphenylolpropane/formaldehyde resins, of diphenylolmethane/formaldehyde resins, of phenol/formaldehyde resins and of cresol/formaldehyde resins.

The epoxy resin composition of the present invention comprises at least one epoxy compound. Therefore the epoxy resin composition of the present invention may also comprise mixtures of at least two epoxy compounds, preferably of at least two of the above epoxy compounds, most preferably of one or more of the above non halogenated epoxy compounds and of one or more of the above halogenated epoxy compounds.

The type of curing compound used in the composition of the present invention is not critical and will depend to a large extent on the type of epoxy resin compound used therein. The amount of curing compound used should be sufficient to obtain full cure.

Suitable curing compounds typically used in epoxy resin compositions for electrical and electronics applications are for example amines, amides, and anhydrides. Particularly suitable amine curing compounds are for example diaminodiphenylmethane (DDM), isophoronediamine (IPD) and dicyandiamide (DICY). The preferred amount of amine curing compound used in the epoxy resin composition of the present invention is such that the ratio of equivalents of amino hydrogen to equivalents of epoxy is in the range of from 0.9 to 1.5, preferably in the range of from 0.9 to 1.1 and most preferably 1.0.

The epoxy resin composition of the present invention may further comprise a cure accelerator and/or other additives commonly used in the art, such as fillers and colouring agents.

The compositions of the present invention may be prepared and by methods known in the art for example by blending or mixing the ingredients in a desired sequence and manner.

As indicated above the epoxy resin compositions of the present invention are particularly suitable for use in the electronics and electrical applications however other end uses include their use in coatings, adhesives, floorings etc.

The invention thereofore also relates to articles and in particular printed wiring boards comprising a composition of the present invention in the cured state.

### MATERIALS

### Epoxy resin compounds

- EPIKOTE 825, (EPIKOTE is a tradename), available from Shell International Chemicals Company, a diglycidylether of diphenylolpropane (bisphenol A) having an EGC of 5712 mmol/kg
- The diglycidylether of tetrabromodiphenylolpropane (tetrabromobisphenol A) having an EGC of 2960 mmol/kg.

### Curing agents

- Isophoronediamine (IPD).
- Diaminodiphenylmethane (DDM).

### Phosphorous containing compounds according to the general formula I

- The diglycidylether of di(3-hydroxypropyl)-2-methylpropylphosphine oxide (DGE-FRD) having an EGC of 5871 mmol/kg.
- The triglycidylether of tri(3-hydroxypropyl)phosphine oxide (TGE-FRT) having an EGC of 7420 mmol/kg.

### Prior art phosphorous containing compounds

- Tri(3-hydroxypropyl)phosphine oxide (FRT)
- Di(3-hydroxypropyl)-2-methylpropylphosphine oxide (FRD)

### PROCESS FOR THE PREPARATION OF PHOSHORUS CONTAINING COMPOUNDS OF THE GENERAL FORMULA 1

### a) Process for the preparation of DGE-FRD.

A round glass reactor of appropriate size was equipped with a heating mantle, an anchor-rotary stirrer, a thermocouple, a water separator, and two reflux condensers that were arranged serially.

The uppermost of these condensers was connected to a vacuum pump with an in-line dry-ice trap. The applied vacuum was controlled with the aid of a Bünchi 168 Vacuum/Distillation Controller. Also connected directly to the reactor was a Labotron LDP-26 metering displacement pump.

11 mol ECH(1017.5 g), 1.1 mol FRD (244 g) and 0.03 mol benzyltriethylammoniumchloride (BETEC) (6.3 g) are mixed in the reactor and heated to 55 °C. A vacuum is applied (typically 140-145 mbar) sufficient to effect reflux of the reaction mixture. Whilst maintaining these conditions, 4.4 mol NaOH (176 g) as a 50% aqueous solution was added dropwise in three equal portions over a period of 3 h. During the NaOH dosing the vacuum is adjusted so as to allow the azeotropic distillation of a mixture of ECH and water, and this mixture is collected in the water trap.

The water is separated, and the ECH returned to the main reactor vessel.

### Post reaction:

After complete dosing of the NaOH solution, the reaction mixture is stirred for a further 1.5 h at 55 °C and 140-145 mbar.

### Work-up:

Water is added to the reaction mixture, and the formed brine is separated. CH₂Cl₂ is then added and the resultant solution washed, first with 10% aqueous Na₂HPO₄ solution until neutral, and then with water. The solvent and residual ECH are removed by reduced pressure rotary evaporation until end conditions of 120 °C and 20 mbar are reached. 50 ml Of water is then added and this is again stripped by rotary evaporation to the same final conditions. 357 g Of a viscious liquid resin was obtained.

### b) Process for the preparation of TGE-FRT.

The procedure as described above was repeated, using 11 mol ECH (1017.5 g), 1.1 mol FRT (248 g), 0.03 mol BETEC (6.3 g) and 3.51 mol DMSO (275 g) as starting materials and 6.6 mol NaOH (264 g) as a 50% aqeuous solution. In the end 1880 g of a viscous liquid resin was obtained.

Characteristics of the products obtained in the above processes are presented below.

| | Mass Yield | M_{w} | %P¹⁾ | EGC mmol/g |
|---|---|---|---|---|
| DGE-FRD | 96% | 334 | 9.3 | 5.92 |
| TGE-FRT | 64% | 392 | 7.9 | 7.42 |

| | | | | |
|---|---|---|---|---|
| 1) weight % phosphorous | | | | |

### PREPARATION OF CASTINGS

Castings of comparative compositions and of compositions according to the invention were prepared by mixing the various components in the ratios according to the data given in tables 1 to 3. In some cases warming was required. The homogeneous liquids obtained were poured into aluminium tube moulds which had been pretreated with suitable release agents. The resin formulations were than heated beween 150 and 200 C for a suitable time to obtain full cure.

### DETERMINATION OF CASTING PROPERTIES

Samples cut from the castings in accordance with the specifications were subjected to the Underwriter Laboratories' UL-94 "Standard for tests for flammability and of plastic material for parts in devices and applicances" fourth edition, June 18, 1991, for the determination of the burn time, the dripping behaviour and cotton ignition thereof and for classifying the materials as 94 V=0, 94 V=1 or 94 V=2. The Tan delta (E"/E') (DMA) was determined according to Dynamic Mechanical Analysis.

### RESULTS

- In tables 1,2 and 3 formulation data and casting properties of compositions according to the invention A to H and of comparative compositions 1 to 10 are presented.
   It should be noted that the relative amounts of each component in the formulations is governed by the mass percentage of phosphorous and bromine required in the final casting. When comparing the respective compositions it is most important that the mass percentages of phosphorous and optionally bromine are the same.
- Table 1 shows compositions according to the invention A to D comprising TGE-FRT. It can be seen that all compositions A to D give an UL-94 V=0 rating and show excellent results in the other tests. Note that it has not been possible to prepare comparative compositions comprising FRT instead of TGE-FRT. FRT is a solid material which proved highly insoluble in the epoxy resin compound(s). Even upon heating, a homogeneous solution of FRT in the epoxy resin compound(s) could not be obtained.
- In table 2 compositions according to the invention E to H and comparative compositions 1 to 4 are shown.

When comparing compositions E with 1, F with 2, G with 3 and H with 4, it can be concluded that the use of DGE-FRD gives higher an delta's than castings containing a level of FRD that gives the same mass percentage of phosphorous. Further it can be seen that all compositions A to D give a UL-94 V=0 rating and excellent results in the other tests.
- In table 3 comparative compositions 5 to 10 are shown. It follows therefrom that only compositions 9 and 10 comprising 20 % by weight of bromine give a UL-94 V=0 rating.

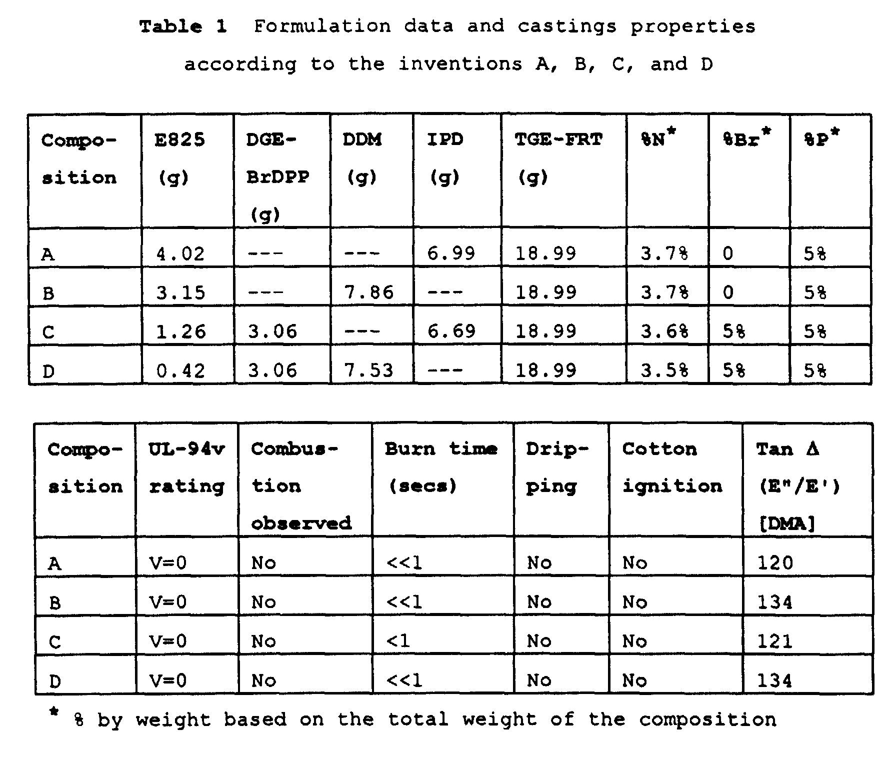

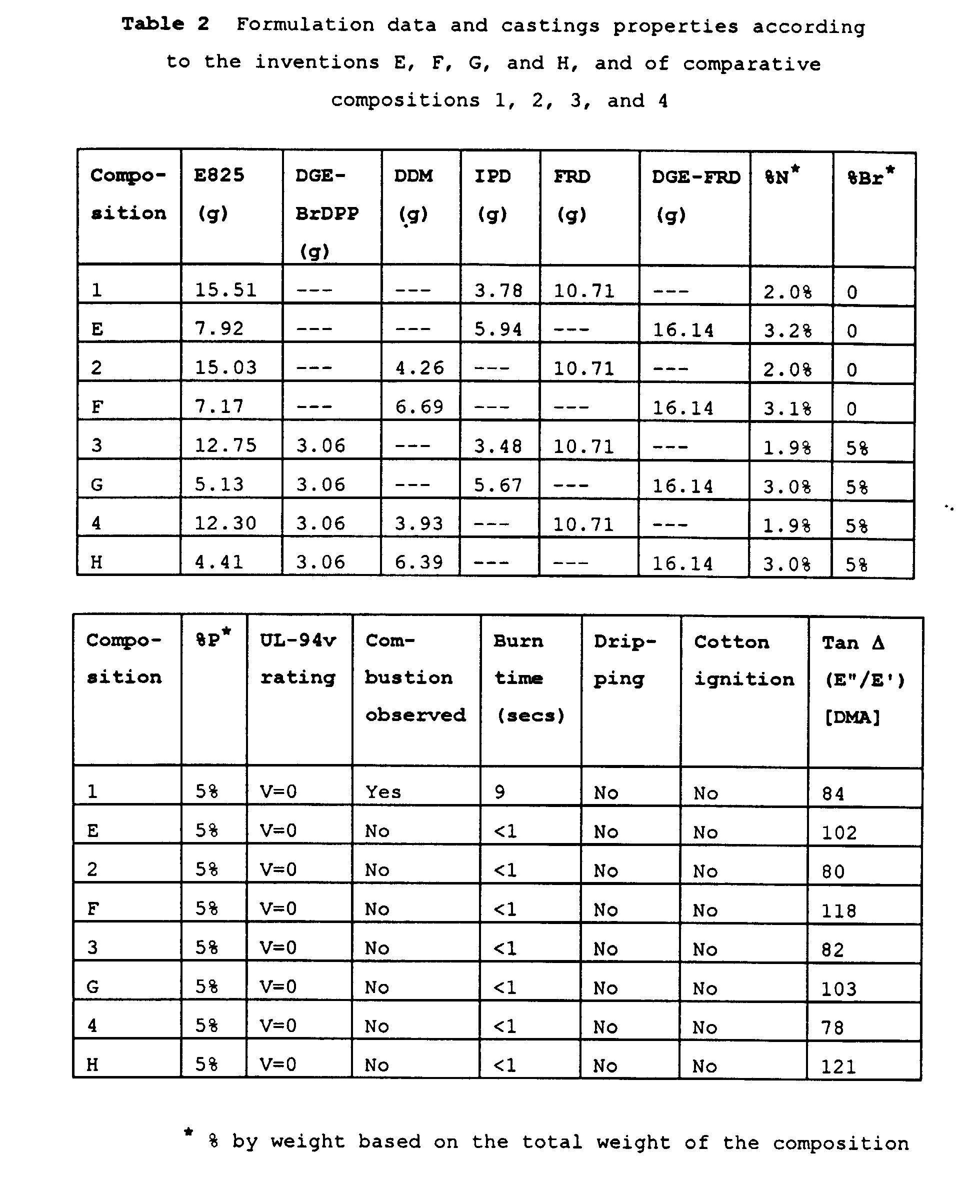

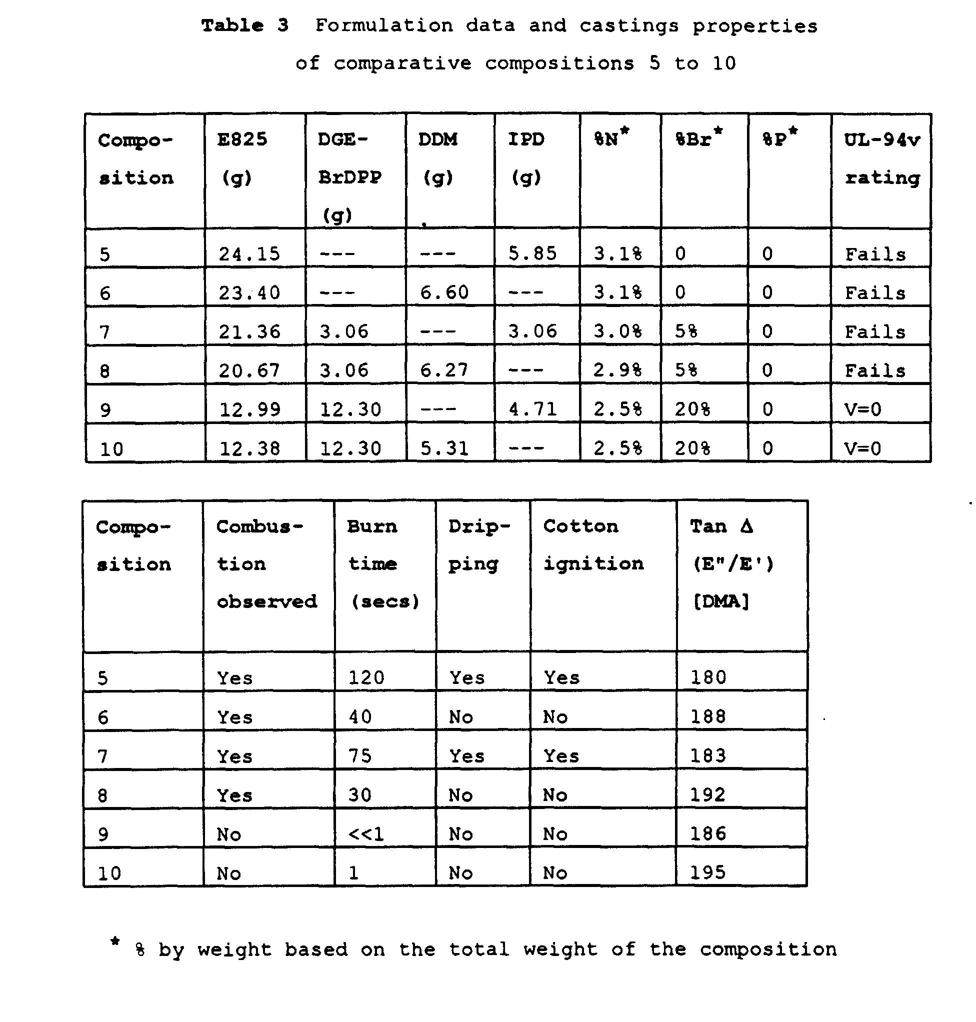

## Claims

1. A polyglycidylether according to the general formula I 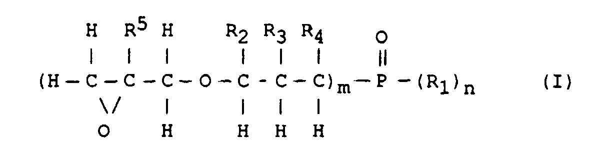
- wherein m is 2 or 3, n is 0 or 1 and m+n is 3,
- wherein wherein R₁ is a radical of an optionally branched alkyl group having from 1 to 6 carbon atoms, of a cycloaliphatic group or of an aromatic group,
- wherein each R₂ and R₃ may individually be a radical of hydrogen or of a linear alkyl group having from 1 to 4 carbon atoms,
- wherein R₄ is a radical of hydrogen or of a linear alkyl group having from 1 to 4 carbon atoms, or of an aromatic group and
- wherein R₅ is a radical of hydrogen or of a methyl group.

2. A polyglycidylether as claimed in claim 1 wherein
- R₁ is a radical of an optionally branched alkyl group having from 1 to 6 carbon atoms,
- wherein R₂, R₃ and R₄ are each individually a radical of hydrogen or of a methyl- , ethyl- or propyl group and
- wherein R₅ is a radical of hydrogen.

3. A polyglycidylether as claimed in claim 2
- wherein R₁ is a radical of an optionally branched a methyl-, ethyl-, propyl-, isopropyl-, butyl- or sec-butyl group and
- wherein each R₂, R₃, R₄ and R₅ are a radical of hydrogen.

4. The triglycidylether of tri(3-hydroxypropyl)phosphine oxide (TGE-FRT) and the diglycidylether of di(3-hydroxypropyl)2-methylpropylphosphine oxide (DGE-FRD).

5. A curable fire retardant epoxy resin composition comprising
a) at least one phosphorous free epoxy resin compound,
b) at least one polyglycidylether as claimed in any one of the claims 1 to 4 and
c) a curing compound.

6. A composition as claimed in claim 5 wherein the percentage of phosphorous is of from 1 to 7 percent by weight, more preferably from 3 to 7 percent by weight, based on the total weight of the composition.

7. A composition as claimed in claims 5 or 6 wherein the epoxy resin compound is:
- the diglycidylether of diphenylolpropane, of diphenylolmethane or of tetrabromodiphenylolpropane or an advanced product of one of the said diglycidylethers or
- a polyglycidylether of a diphenylolpropane/formaldehyde resin, of a diphenylolmethane/formaldehyde resin, of a phenol/formaldehyde resin or of a cresol/formaldehyde resin.

8. A composition as claimed in claims 5 to 7 comprising a mixture of one or more non halogenated epoxy compound(s) and of one or more halogenated epoxy compound(s).

9. A composition as claimed in any one of the claims 5 to 8 wherein the halogen content is 15% or less by weight based on the total weight of the composition.

10. A composition as claimed in any one of the claims 5 to 9 wherein the curing compound is an amine, a carboxylic acid anhydride or an amide.

11. A composition as claimed in claim 10 wherein the amine curing compound is diaminodiphenylmethane (DDM), isophoronediamine (IPD) or dicyandiamide (DICY).

12. A process for the preparation of a polyglycidylether as claimed in any one of the claims 1 to 4 by reacting the precursor 3-hydroxyalkylphosphine oxide compound with a suitable amount of epihalohydrin, preferably epichlorohydrin, in the presence of a suitable base or acid catalyst.

13. A process for the preparation of a composition as claimed in any one of the claims 5 to 11 by blending or mixing the ingredients in a desired sequence and manner.

14. Use of a composition as claimed in any one of the claims 5 to 11 in the preparation of a printed wiring board.

15. Articles whenever comprising a composition as claimed in any one of the claims 5 to 11 in the cured state.

16. An article as claimed in claim 15 the article being a printed wiring board.

## Patentansprüche

1. Ein Polyglycidylether entsprechend der allgemeinen Formel I 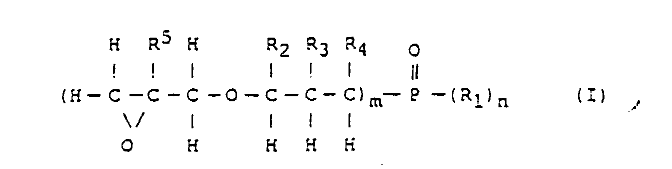
- worin m den Wert 2 oder 3 aufweist, n für 0 oder 1 steht und m+n den Wert 3 hat und
- worin R₁ eine gegebenenfalls verzweigte Alkylgruppe mit 1 bis 6 Kohlenstoffatomen oder eine cycloaliphatische Grupe oder eine aromatische Gruppe bedeutet,
- worin jeder der Reste R₂ und R₃ jeweils für sich Wasserstoff oder eine lineare Alkylgruppe mit 1 bis 4 Kohlenstoffatome bedeutet,
- worin R₄ Wasserstoff oder eine lineare Alkylgruppe mit 1 bis 4 Kohlenstoffatomen oder eine aromatische Gruppe darstellt und
- worin R₅ Wasserstoff oder eine Methylgruppe bedeutet.

2. Polyglycidylether nach Anspruch 1, worin
- R₁ eine gegebenenfalls verzweigte Alkylgruppe mit 1 bis 6 Kohlenstoffatomen darstellt,
- R₂, R₃ und R₄ jeweils für sich Wasserstoff oder eine Methyl-, Ethyl- oder Propylgruppe darstellen und
- R₅ Wasserstoff bedeutet.

3. Polyglycidylether nach Anspruch 2,
- worin R₁ eine gegebenenfalls verzweigte Methyl-, Ethyl-, Propyl-, Isopropyl-, Butyl- oder sek.Butylgruppe darstellt und
- worin jeder der Reste R₂, R₃, R₄ und R₅ Wasserstoff bedeutet.

4. Triglycidylether von Tri(3-hydroxypropyl)phosphinoxid (TGE-FRT) und der Diglycidylether von Di(3-hydroxypropyl)-2-methylpropylphosphinoxid (DGE-FRD).

5. Härtbare feuerverzögernde Epoxyharzzusammensetzung, umfassend
a) wenigstens eine phosphorfreie Epoxyharzverbindung,
b) wenigstens einen Polyglycidylether, wie in einem der Ansprüche 1 bis 4, beansprucht und
c) eine Härtungsverbindung.

6. Zusammensetzung nach Anspruch 5, worin der Prozentsatz an Phosphor von 1 bis 7 Gew.-%, stärker bevorzugt von 3 bis 7 Gew.-% beträgt, bezogen auf das Gesamtgewicht der Zusammensetzung.

7. Zusammensetzung nach den Ansprüchen 5 oder 6, worin die Epoxyharzverbindung:
- der Diglycidylether von Diphenylolpropan, von Diphenylolmethan oder von Tetrabromdiphenylolpropan oder ein weiter kondensiertes Produkt eines dieser Diglycidylether ist, oder
- ein Polyglycidylether eines Diphenylolpropan/Formaldehydharzes, eines Diphenylolmethan/Formaldehydharzes, eines Phenol/Formaldehydharzes oder eines Cresol/Formaldehydharzes ist.

8. Zusammensetzung nach den Ansprüchen 5 bis 7, umfassend ein Gemisch aus einer oder mehreren nichthalogenierten Epoxyverbindungen mit einer oder mehreren halogenierten Epoxyverbindungen.

9. Zusammensetzung nach einem der Ansprüche 5 bis 8, worin der Halogengehalt 15 Gew.-% oder weniger, bezogen auf das Gesamtgewicht der Zusammensetzung, beträgt.

10. Zusammensetzung nach einem der Ansprüche 5 bis 9, worin die Härtungsverbindung ein Amin, ein Carbonsäureanhydrid oder ein Amid ist.

11. Zusammensetzung nach Anspruch 10, worin die Aminhärtungsverbindung Diaminodiphenylmethan (DDM), Isophorondiamin (IPD) oder Dicyandiamid (DICY) ist.

12. Verfahren zur Herstellung eines Polyglycidylethers nach einem der Ansprüche 1 bis 4, durch Umsetzen der 3-Hydroxyalkylphosphinoxid-Vorläuferverbindung mit einer geeigneten Menge Epihalogenhydrin, vorzugsweise Epichlorhydrin, in Gegenwart eines geeigneten basischen oder sauren Katalysators.

13. Verfahren zur Herstellung einer Zusammensetzung nach einem der Ansprüche 5 bis 11 durch Vermischen der Bestandteile in einer gewünschten Reihenfolge und Art.

14. Verwendung einer Zusammensetzung nach einem der Ansprüche 5 bis 11 in der Herstellung einer gedruckten Schaltung.

15. Gegenstände, wann immer sie eine Zusammensetzung nach einem der Ansprüche 5 bis 11 im gehärteten Zustand umfassen.

16. Gegenstand nach Anspruch 15, wobei der Gegenstand eine gedruckte Schaltung ist.

## Revendications

1. Ether polyglycidylique suivant la formule générale I : 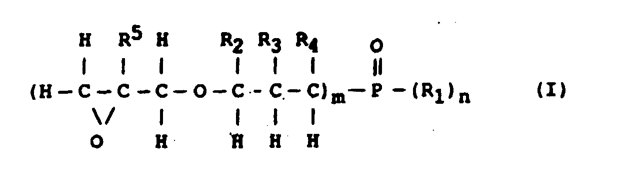
- dans laquelle m est égal à 2 ou 3, n est égal à 0 ou 1 et m+n est égal à 3, et
- dans laquelle R₁ est un radical d'un groupe alkyle éventuellement ramifié comportant de 1 à 6 atomes de carbone, d'un groupe cycloaliphatique ou d'un groupe aromatique,
- dans laquelle chacun des R₂ et R₃ peut individuellement être un radical d'hydrogène ou d'un groupe alkyle linéaire comportant de 1 à 4 atomes de carbone,
- dans laquelle R₄ est un radical d'hydrogène ou d'un groupe alkyle linéaire comportant de 1 à 4 atomes de carbone, ou d'un groupe aromatique, et
- dans laquelle R₅ est un radical d'hydrogène ou d'un groupe méthyle.

2. Ether polyglycidylique suivant la revendication 1, dans lequel:
- R₁ est un radical d'un groupe alkyle éventuellement ramifié comportant de 1 à 6 atomes de carbone,
- dans lequel R₂, R₃ et R₄ sont chacun individuellement un radical d'hydrogène ou d'un groupe méthyle, éthyle ou propyle, et
- dans lequel R₅ et un radical d'hydrogène.

3. Ether polyglycidylique suivant la revendication 2,
- dans lequel R₁ est un radical d'un groupe méthyle, éthyle, propyle, isopropyle, butyle ou sec-butyle éventuellement ramifié, et
- dans lequel chacun des R₂, R₃, R₄ et R₅ est un radical d'hydrogène.

4. L'éther triglycidylique d'oxyde de tri(3-hydroxypropyl)-phosphine (TGE-FRT) et l'éther diglycidylique d'oxyde de di(3-hydroxypropyl)-2-méthylpropylphosphine (DGE-FRD).

5. Composition de résine époxy résistante au feu durcissable comprenant :
a) au moins un composé de résine époxy sans phosphore,
b) au moins un éther polyglycidylique suivant l'une quelconque des revendications 1 à 4, et
c) un composé de durcissement.

6. Composition suivant la revendication 5, dans laquelle le pourcentage de phosphore est de 1 à 7% en poids, plus avantageusement de 3 à 7 % en poids, par rapport au poids total de la composition.

7. Composition suivant l'une ou l'autre des revendications 5 et 6, dans laquelle le composé de résine époxy est :
- l'éther diglycidylique de diphénylolpropane, de diphénylolméthane ou de tétrabromodiphénylolpropane ou un produit dérivé d'un de ces éthers diglycidyliques, ou
- un éther polyglycidylique d'une résine de diphénylolpropane/formaldéhyde, d'une résine de diphénylolméthane/formaldéhyde, d'une résine de phénol/formaldéhyde ou d'une résine de crésol/formaldéhyde.

8. Composition suivant l'une quelconque des revendications 5 à 7, comprenant un mélange d'un ou plusieurs composés époxy non halogénés et d'un ou plusieurs composés époxy halogénés.

9. Composition suivant l'une quelconque des revendications 5 à 8, dans laquelle la teneur en halogène est de 15 % en poids ou moins par rapport au poids total de la composition.

10. Composition suivant l'une quelconque des revendications 5 à 9, dans laquelle le composé de durcissement est une amine, un anhydride d'acide carboxylique ou un amide.

11. Composition suivant la revendication 10, dans laquelle le composé de durcissement d'amine est le diaminodiphénylméthane (DDM), l'isophoronediamine (IPD) ou le dicyandiamide (DICY).

12. Procédé de préparation d'un éther polyglycidylique suivant l'une quelconque des revendications 1 à 4, par la réaction du composé précurseur d'oxyde de 3-hydroxyalkylphosphine avec une quantité appropriée d'épihalohydrine, avantageusement d'épichlorhydrine, en présence d'un catalyseur de base ou d'acide approprié.

13. Procédé de préparation d'une composition suivant l'une quelconque des revendications 5 à 11, par le malaxage ou mélange des ingrédients suivant une séquence et d'une manière désirées.

14. Utilisation d'une composition suivant l'une quelconque des revendications 5 à 11, dans la préparation d'une carte de câblage imprimé.

15. Articles lorsque comprenant une composition suivant l'une quelconque des revendications 5 à 11 à l'état durci.

16. Article suivant la revendication 15, ledit article étant une carte de câblage imprimé.
